# EUROPÄISCHE PATENTSCHRIFT

(11) **EP 3 317 742 B1**
(45) Veröffentlichungstag und Bekanntmachung des Hinweises auf die Patenterteilung: **22.06.2022**
(21) Anmeldenummer: 16740975.4
(22) Anmeldetag: 30.06.2016
(51) Int. Cl.: G06F 1/02, G06F 1/025, H01J 37/32, H03K 5/00

(54) **VORRICHTUNG UND VERFAHREN ZUR ERZEUGUNG MEHRERER TAKT- ODER HOCHFREQUENZSIGNALE**
DEVICE AND METHOD FOR GENERATING A PLURALITY OF CLOCK SIGNALS OR HIGH-FREQUENCY SIGNALS
DISPOSITIF ET PROCÉDÉ POUR GÉNÉRER PLUSIEURS SIGNAUX D'HORLOGE OU DE HAUTE FRÉQUENCE

(30) Priorität: 30.06.2015 DE 102015212243
(43) Veröffentlichungstag der Anmeldung: 09.05.2018
(73) Patentinhaber: TRUMPF Hüttinger GmbH + Co. KG, 79111 Freiburg (DE)
(72) Erfinder: GREDE, André, 3018 Bern (CH); GRUNER, Daniel, 79379 Muellheim (DE); BANNWARTH, Armin, 79183 Waldkirch (DE); BOCK, Christian, 79108 Freiburg (DE); HOFSTETTER, Christoph, 79331 Teningen (DE); PENA VIDAL, Alberto, 79104 Freiburg (DE); SCHWERG, Nikolai, 1202 Genève (CH); VOR DEM BROCKE, Manuel, 79100 Freiburg (DE); WINTERHALTER, Markus, 79189 Bad Krozingen (DE)
(74) Vertreter: Trumpf Patentabteilung
(86) Internationale Anmeldenummer: PCT/EP2016/065386
(87) Internationale Veröffentlichungsnummer: WO 2017/001603

(56) Entgegenhaltungen:
- EP-A1- 1 753 011
- WO-A2-2014/094738
- DE-A1- 19 751 269
- US-A1- 2003 095 068
- US-A1- 2005 177 758
- US-A1- 2009 167 375
- US-A1- 2014 240 004
- US-B1- 6 429 796

## Beschreibung

Die Erfindung betrifft eine Vorrichtung zur Erzeugung mehrerer Takt- oder Hochfrequenzsignale.

Weiterhin betrifft die Erfindung ein Verfahren zur Erzeugung mehrerer Takt- oder Hochfrequenzsignale.

Vorrichtungen und Verfahren solcher und ähnlicher Art sind z.B. aus den folgenden Schriften bekannt: US7,624,296 B2, DE 10 2013 226 537 A1, US2005/0177758 A1, US2003/0095068 A1, US2014/0263199 A1, US6,884,635 B2, US8,692,467 B2, US5,932,116 A, US5,824,606 A.

US 6429796 B1 offenbart eine Schaltungsanordnung zum automatisierten Test von elektronischen Schaltkreisen zur Generierung von programmierbaren Signalen hoher Reinheit mit niedrigem Rauschen und geringem Anteil von unerwünschten Frequenzanteilen. Dafür wird vorgeschlagen einen DDS (direct digital synthesizer) mit zumindest zwei unabhängig programmierbaren Ausgängen und einem Taktgenerator einzusetzen, der diesen DDS mit einem hochreinen Takt versorgt. Die Reinheit des Takts wird sichergestellt durch einen Oszillator, der zur Unterdrückung von Frequenzschwankungen mit einem regelbaren Ofen auf konstanter Temperatur gehalten wird.

EP 1753011 A1 offenbart ein Verfahren zur Erzeugung von zumindest zwei Ansteuersignalen, die einen Plasmaprozess mit HF-Leistung versorgen, wobei die Ansteuersignale unter Verwendung je eines digitalen Funktionsgenerators, der als DDS ausgebildet sein kann, erzeugt werden.

US 2005/ 177758 A1 offenbart ein Abtastsystem, das Hochgeschwindigkeitsdatensignale durch Ausführen von Abtastereignissen in Intervallen, die durch eine programmierbare DDS-Ausgangsfrequenz bestimmt sind, und mit Hilfe eines programmierbaren Zählers, misst. Die Referenzfrequenz des DDS ist die eines Taktsignals, das synchron mit dem zu messenden Datensignal ist. Damit kann die Abtastung synchron mit dem Datentakt erfolgen und die Phase des synthetisierten Signals kann derart gesteuert werden, dass die Abtastungen um die ansteigenden und abfallenden Flanken der Datenwellenform lokalisiert sind. Damit können Ort der Kanten der Datensignale bestimmt und der Jitter der Wellenform analysiert werden.

WO 2014/094738 A2 offenbart ein Verfahren zur Löschung von Arcs in einer Plasmakammer mit: Erzeugung einer Leistung, indem mit einem DAC ein Analogsignal generiert wird, das einem Verstärkerpfad zugeführt wird, Überwachung des Plasmasystems hinsichtlich des Auftretens eines Arcs und bei Erkennen eines Arcs: Ansteuern des DACs derart, dass ein analoges Ausgangssignal des DACs verändert wird.

Bei Hochfrequenzanwendungen, insbesondere bei der Erzeugung von Hochfrequenzleistung zum Betrieb eines Plasmaprozesses bestehen bestimmte Anforderungen. Zum einen soll der Jitter zwischen dem Hochfrequenzausgangsleistungssignal und einer Abtastrate bei einer Hochfrequenzmessung zur Maximierung der Messgenauigkeit minimiert werden. Die Abtastrate soll dabei der Frequenz des Hochfrequenzausgangssignals synchron und augenblicklich folgen. Es bestehen also Anforderungen bezüglich Frequenzvariation und Frequenzagilität.

Außerdem besteht der Bedarf einer Phasenregelung der Hochfrequenzausgangsleistung. Darüber hinaus besteht die Anforderung, Taktsignale verarbeiten zu können und bereitstellen zu können.

Aufgabe der vorliegenden Erfindung ist es, eine Vorrichtung und ein Verfahren bereitzustellen, mit denen die oben genannten Anforderungen erfüllt werden können.

Gelöst wird diese Aufgabe erfindungsgemäß durch eine Vorrichtung nach Anspruch 1 und ein Verfahren nach Anspruch 11. Vorteilhafte Weiterbildungen finden sich in den abhängigen Ansprüchen. Offenbart ist dafür eine Vorrichtung zur Erzeugung mehrerer Takt- oder Hochfrequenzsignale,
a) mit einem Referenzfrequenzerzeuger, der an einen Oszillator angeschlossen ist und an seinem Ausgang ein Referenzsignal mit einer Referenzfrequenz fx erzeugt, sowie
b) mit zumindest einem ersten, einem zweiten und einem weiteren Signalverarbeitungsbaustein, insbesondere DDS, die über eine erste Signalleitung mit dem Referenzfrequenzerzeuger verbunden sind und denen das Referenzsignal mit der Referenzfrequenz fx zugeführt wird und die konfiguriert sind, jeweils ein Ausgangssignal mit einer Frequenz < fx zu erzeugen, wobei
c) der erste Signalverarbeitungsbaustein dazu ausgelegt ist, aus der Referenzfrequenz fx ein Ausgangssignal mit einer per Software definierten Frequenz und Phase zu erzeugen, sowie
d) mit einem Leistungserzeuger, der den zweiten Signalverarbeitungsbaustein aufweist, wobei der Ausgang des zweiten Signalverarbeitungsbausteins mit einem Leistungsverstärker verbunden ist, der eingerichtet ist, aus dem Ausgangsignal des zweiten Signalverarbeitungsbausteins ein Hochfrequenzleistungssignal zu erzeugen, sowie
e) mit einer digitalen Messeinrichtung, die mit einem Sensor am Ausgang des Leistungserzeugers verbunden ist, wobei der Ausgang des weiteren Signalverarbeitungsbausteins mit einem Takteingang der Messeinrichtung verbunden ist, um der Messeinrichtung eine Abtastfrequenz zuzuführen, wobei
f) die Messeinrichtung einen A/D-Wandler aufweist, dem die Abtastfrequenz zugeführt ist und der mit dem Sensor verbunden ist.

Z Folglich sind mehrere Signalverarbeitungsbausteine vorgesehen, die konfiguriert sind, ein Ausgangssignal mit einer Frequenz < fx zu erzeugen. Die von den Signalverarbeitungsbausteinen erzeugten Ausgangssignale können dabei unterschiedliche Frequenzen aufweisen. Die Ausgangssignale, also die Takt- und Hochfrequenzsignale, sind dabei frei skalierbar und genügen den hohen Anforderungen bezüglich Frequenz- und Phasenstabilität.

Bei dem Oszillator kann es sich um einen Oszillator handeln, der eine hohe Frequenz erzeugt, insbesondere eine Frequenz > fx und mit niedrigem Jitter.

Wird die Referenzfrequenz von einem Oszillator mit höherer Frequenz abgeleitet, so verringert sich der Jitter des Referenzsignals quasi proportional zum Jitter des Oszillatorsignals. Vorzugsweise hat das Oszillatorsignal eine Frequenz, die mindestens um den Faktor 3 bis 5 größer ist als das Referenzsignal. Beispielsweise kann ein Oszillator verwendet werden, der ein Oszillatorsignal mit einer Frequenz von 1GHz ausgibt. Daraus können Referenzsignale mit Frequenzen von ca. 50 MHz bis 500 MHz abgeleitet werden.

Zumindest einer der Signalverarbeitungsbausteine kann konfiguriert sein, ein Ausgangssignal mit einer Frequenz n/m ^{∗} fx (also n/m mal fx) mit n, m ∈ N (n, m sind natürliche Zahlen) und vorzugsweise m > n zu erzeugen. Dadurch, dass ein Referenzsignal mit einer Referenzfrequenz fx erzeugt wird, können allen anderen Signale durch n/m Vielfache aus dieser Referenzfrequenz abgeleitet werden. Zur Erzeugung der diversen Ausgangssignale werden vorzugsweise Direct Digital Synthesis-Bausteine (DDS) verwendet, deren Amplitude, Frequenz und Phase während des Betriebes digital eingestellt werden können. Frequenzänderungen der Referenzfrequenz werden augenblicklich entsprechend des eingestellten Frequenzverhältnisses n/m am Ausgang der Signalverarbeitungsbausteine sichtbar. Aus diesem Signal kann mit Hilfe von Leistungsverstärkern ein Hochfrequenzleistungssignal mit entsprechender Amplitude, Frequenz und Phase erzeugt werden. Hierbei kann für jeden Signalverarbeitungsbaustein eine eigene Konfiguration gewählt werden, die sich insbesondere in der Wahl der Werte für n und m und damit der erzeugten Frequenz unterscheidet. Der Referenzfrequenzerzeuger kann eingerichtet sein, ein Synchronisationssignal, insbesondere mit einer Frequenz fx/k (also fx geteilt durch k), k ∈ N (k ist eine natürliche Zahl), zu erzeugen, wobei der Referenzfrequenzerzeuger über eine zweite Signalleitung mit zumindest einem der

Signalverarbeitungsbausteine verbunden ist. Wie oben erwähnt, sind vorzugsweise mehrere Signalverarbeitungsbausteine vorgesehen, denen jeweils das Synchronisationssignal zugeführt wird. Durch die Verwendung eines solchen Synchronisationssignals können alle aus der Referenzfrequenz abgeleiteten Signale starr in der Phase an die Referenzfrequenz gebunden werden.

Die Signalleitungen können zum Ausgleich von Signallaufzeiten in definierter Länge zueinander sein. Die Längen der Signalleitungen können also so aufeinander abgestimmt sein, dass die Signallaufzeiten auf den Signalleitungen gleich sind.

Zumindest einer der Signalverarbeitungsbausteine kann durch ein Konfigurationswort digital einstellbar sein, wobei das Konfigurationswort die Frequenz, die Phase und/oder die Amplitude bezüglich des Referenzsignals des vom Signalverarbeitungsbaustein erzeugten Ausgangssignals bestimmt. Durch zyklische Vorgabe des Konfigurationswortes können dynamisch angepasste Amplituden und Phasen des Ausgangssignals eingestellt werden.

Dem Referenzfrequenzerzeuger kann ein externes Taktsignal zugeführt sein, wobei der Referenzfrequenzerzeuger eingerichtet ist, die Frequenz des externen Taktsignals zu ermitteln und auf die Referenzfrequenz umzusetzen. Durch den Referenzfrequenzerzeuger kann dadurch der Jitter des externen Taktsignals eliminiert werden, indem das Referenzsignal mit derselben Frequenz wie das externe Taktsignal generiert wird. Dadurch, dass das Referenzsignal neu generiert wird, weist es einen geringeren Jitter auf. Außerdem können externe Taktsignale höherer oder niedrigerer Frequenz relativ umgesetzt werden, d.h. es kann ein Referenzsignal erzeugt werden, das eine andere Frequenz hat als das externe Signal, das aber einer Frequenzänderung des externen Signals folgt.

Der erste Signalverarbeitungsbaustein kann mit seinem Signalausgang an einen Phasenkomparator angeschlossen sein, dem auch das externe Taktsignal zugeführt ist, wobei der Ausgang des Phasenkomparators mit dem ersten Signalverarbeitungsbaustein verbunden ist. Auf diese Art und Weise kann mithilfe eines Signalverarbeitungsbausteins eine Bezugsphase erzeugt werden. Die Bezugsphase kann mithilfe des Phasenkomparators auf das Eingangssignal, d.h. das externe Taktsignal, abgeglichen werden. Eine Phasendifferenz zwischen dem externen Taktsignal und dem Ausgangssignal des Signalverarbeitungsbausteins kann ausgeregelt werden, insbesondere durch Variation des Phasenwerts im Konfigurationswort. Bei der Phasenregelung wird die Phase des Ausgangssignals systematisch entgegen der Phase des Referenzsignals verschoben, so dass die Phasendifferenz des Ausgangssignals und des externen Taktsignals konstant zueinander bleiben.

Das Ausgangssignal des ersten Signalverarbeitungsbausteins kann als Bezugsphase verwendet werden und ermöglicht eine Phasenregelung des Hochfrequenzleistungssignals auch beim Fehlen eines externen Taktsignals oder bei Betrieb mit einer von dem externen Taktsignal abweichenden Betriebsfrequenz, um beispielsweise leistungsabhängige Phasenänderungen des Leistungserzeugers auszuregeln. Damit kann ein Leistungserzeuger zudem mit einem Frequenzoffset gegenüber dem externen Signal betrieben werden, und, obwohl zwischen diesen beiden Signalen keine konstante Phasenbeziehung hergestellt werden kann, kann dennoch die Phase des Hochfrequenzleistungssignals auf diese interne Bezugsphase geregelt werden.

Der Ausgang des ersten Signalverarbeitungsbausteins kann mit einem ersten Umschalter verbunden sein, dem auch das externe Taktsignal zugeführt ist. Durch den Umschalter kann entweder das externe Taktsignal direkt auf einen Taktausgang der Vorrichtung gegeben werden oder das Ausgangssignal am Ausgang des ersten Signalverarbeitungsbausteins kann extern verfügbar gemacht werden, indem es an den Taktausgang gegeben wird.

Wie zuvor erwähnt, ist ein Leistungserzeuger vorgesehen, der zumindest einen zweiten Signalverarbeitungsbaustein aufweist, wobei der Ausgang zumindest eines zweiten Signalverarbeitungsbausteins mit einem Leistungsverstärker verbunden ist, der eingerichtet ist, aus dem Ausgangssignal des Signalverarbeitungsbausteins ein Hochfrequenzleistungssignal zu erzeugen.

Wie zuvor erwähnt, ist eine digitale Messeinrichtung vorgesehen, die mit einem Sensor am Ausgang des Leistungserzeugers verbunden ist. Somit kann die von dem Leistungserzeuger erzeugte HF-Leistung, beziehungsweise ein damit in Beziehung stehendes Hochfrequenzsignal (HF-Signal), z.B. ein Hochfrequenzleistungssignal, erfasst werden. Vorzugsweise weist der Leistungserzeuger mehrere zweite Signalverarbeitungsbausteine auf, die jeweils mit einem Leistungsverstärker verbunden sind, wobei die Leistungen an den Ausgängen der Leistungsverstärker zu einem HF-Ausgangssignal kombiniert werden.

Der Ausgang eines weiteren Signalverarbeitungsbausteins ist mit einem Takteingang der Messeinrichtung verbunden, um der Messeinrichtung eine Abtastfrequenz zuzuführen. Es erfolgt somit eine Verteilung der Signalerzeugung für die Abtastung und die Hochfrequenzleistung auf verschiedene, vorzugsweise identische, Signalverarbeitungsbausteine, die mit auf ihre Aufgabe bezogenen unterschiedlichen Konfigurationsworten konfiguriert werden. Dadurch kann der Jitter zwischen der Hochfrequenzleistung und einer Abtastrate eines Analog-Digital-Wandlers, der bei der HF-Messung eingesetzt wird, minimiert werden. Die Messgenauigkeit kann verbessert werden, wobei die Abtastrate des Analog-Digital-Wandlers der Frequenz des Hochfrequenzleistungssignals synchron folgt.

Die Messeinrichtung kann mit einem Umschalter verbunden sein, dem das externe Taktsignal und das Ausgangssignal des ersten Signalverarbeitungsbausteins zugeführt sind. Dieser Umschalter ermöglicht es, sowohl das externe Taktsignal als auch das Signal mit der Bezugsphase für eine Phasenmessung zu nutzen.

Wie zuvor erwähnt, weist die Messeinrichtung einen Analog-Digital-Wandler auf, dem die Abtastfrequenz zugeführt ist und der mit dem Sensor verbunden ist. Durch den Analog-Digital-Wandler kann somit mit der Abtastfrequenz das Hochfrequenzleistungssignal abgetastet werden. Die Messeinrichtung kann eine Signalverarbeitungseinheit, insbesondere ein FPGA, aufweisen, der das Abtastsignal, das Ausgangssignal des Umschalters und ein Signal des Analog-Digital-Wandlers zugeführt sind und die eingerichtet ist, ein Messergebnis auszugeben. Insbesondere kann unter Verwendung der durch den Umschalter ausgegebenen Referenzphase die Phasenlage des Hochfrequenzleistungssignals bestimmt werden.

In den Rahmen der Erfindung fällt außerdem ein Verfahren zur Erzeugung mehrerer Takt- oder Hochfrequenzsignale, bei dem
a) ein Referenzsignal erzeugt wird und
b) ein erstes, ein zweites und ein weiteres Ausgangssignal anhand des Referenzsignals erzeugt wird, wobei die Frequenz der Ausgangssignale kleiner ist als die Frequenz fx des Referenzsignals, wobei
c) das erste Ausgangssignal mit einer per Software definierten Frequenz und Phase erzeugt wird,
d) das zweite Ausgangssignal einem Leistungsverstärker in einem Leistungserzeuger zugeführt wird, der aus dem Ausgangssignal ein Hochfrequenzleistungssignal erzeugt,
e) das weitere Ausgangssignal einer Messeinrichtung zugeführt wird, die mit einem Sensor am Ausgang des Leistungserzeugers verbunden ist, um der Messeinrichtung eine Abtastfrequenz zuzuführen, wobei
f) die Abtastfrequenz einem A/D-Wandler der Messeinrichtung, der mit dem Sensor verbunden ist, zugeführt wird.

Sämtliche erzeugten Signale weisen somit eine Abhängigkeit von der Referenzfrequenz fx auf und stehen somit in einem Zusammenhang.

Aus dem Referenzsignal kann ein Referenzphasensignal erzeugt werden, das bei einer Messung des Hochfrequenzleistungssignals verwendet werden kann. Somit kann die Phase des Hochfrequenzleitungssignals bestimmt werden.

Aus dem Referenzsignal wird eine Abtastfrequenz erzeugt , die bei der Messung des Hochfrequenzleistungssignals verwendet werden kann. Die Abtastfrequenz kann somit unabhängig von einem Hochfrequenzsignal eines Leistungserzeugers erzeugt werden. Allerdings werden beide Signale gestützt auf das Referenzsignal erzeugt.

Ein Synchronisationssignal, insbesondere mit einer Frequenz fx/k, k ∈ N, vorzugsweise fx/4, kann erzeugt werden, das mehreren Signalverarbeitungsbausteinen zugeführt wird, die anhand der Referenzfrequenz ein Ausgangssignal erzeugen. Somit können alle erzeugten Signale starr in der Phase an die Referenzfrequenz gebunden werden.

Mit der erfindungsgemäßen Vorrichtung und dem erfindungsgemäßen Verfahren ist es auch möglich, ein externes Taktsignal hinsichtlich eines oder mehrerer erlaubter Frequenzbereiche zu überwachen. Das externe Taktsignal kann von Jitter befreit werden. Weiterhin kann ein Leistungserzeuger mit einem externen Taktsignal betrieben werden, das ein n/m Vielfaches mit n, m ∈ N des Hochfrequenzleistungssignals ist.

Für den Leistungserzeuger kann ein jitterarmes Hochfrequenzleistungssignal erzeugt werden, welches anschließend durch Leistungsverstärker verstärkt wird. Ein Frequenzoffset der Hochfrequenzleistung bezogen auf ein externes Taktsignal ist einstellbar.

Der Jitter zwischen dem Hochfrequenzleistungssignal und einer Abtastrate eines Analog-Digital-Wandlers kann minimiert werden. Die Abtastrate des Analog-Digital-Wandlers kann der Frequenz des Hochfrequenzleistungssignals synchron und augenblicklich folgen.

Weiterhin ist eine Phasenmessung zwischen dem Hochfrequenzleistungssignal und dem externen Taktsignal möglich. Weiterhin ist eine Phasenstellung möglich, wenn das externe Taktsignal eine identische Frequenz wie die Generatorfrequenz aufweist.

Zudem ist es möglich, die Hochfrequenzleistung beliebig in der Phase zu regeln.

Weiterhin ist es möglich, ein Ausgangstaktsignal synchron mit der Hochfrequenzleistung bereit zu stellen. Das externe Taktsignal kann von Jitter befreit mit einer festen Phasenbeziehung durch die Vorrichtung geschleift werden. Auch die Hintereinanderschaltung mehrerer Hochfrequenzleistungsgeneratoren zur phasenrichtigen Überlagerung deren Ausgangssignal ist möglich.

Weitere Merkmale und Vorteile der Erfindung ergeben sich aus der nachfolgenden detaillierten Beschreibung eines Ausführungsbeispiels der Erfindung, anhand der Figur der Zeichnung, die erfindungswesentliche Einzelheiten zeigt, sowie aus den Ansprüchen. Die dort gezeigten Merkmale sind nicht notwendig maßstäblich zu verstehen und derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

In der schematischen Zeichnung ist ein Ausführungsbeispiel der Erfindung dargestellt und in der nachfolgenden Beschreibung näher erläutert.

Die einzige Figur zeigt eine Vorrichtung 1, die einen Referenzfrequenzerzeuger 2 aufweist, der mit einem Oszillator 3 verbunden ist. Weiterhin ist der Referenzfrequenzerzeuger 2 mit einem externen Taktsignalanschluss 4 verbunden. Der Referenzfrequenzerzeuger 2 ist eingerichtet, aus dem Signal des Oszillators 3 und/oder dem externen Taktsignal ein Referenzsignal am Ausgang 5 zu erzeugen, welches die Frequenz fx aufweist. Außerdem ist der Referenzfrequenzerzeuger 2 eingerichtet, ein Synchronisationssignal am Ausgang 6 zu erzeugen, welches vorzugsweise die Frequenz fx/4 aufweist. Der Oszillator 3 ist eingerichtet, ein Signal mit einer hohen Frequenz und niedrigem Jitter zu erzeugen. Durch eine Bestimmungseinrichtung 7, die innerhalb oder außerhalb des Referenzfrequenzerzeugers 2 angeordnet sein kann, kann die Frequenz des externen Taktsignals, das über den Anschluss 4 empfangen wird, bestimmt werden. Außerdem kann der Jitter des externen Taktsignals eliminiert werden.

Der Ausgang 5 des Referenzfrequenzerzeugers 2 ist mit einem ersten Signalverarbeitungsbaustein 10, zwei zweiten Signalverarbeitungsbausteinen 11, 12 und einem weiteren Signalverarbeitungsbaustein 14 verbunden. Die Verbindung erfolgt über längenkontrollierte Signalleitungen 15. Ebenso ist der Ausgang 6 über längenkontrollierte Signalleitungen 16 mit den Signalverarbeitungsbausteinen 10 bis 14 verbunden. Die Signalverarbeitungsbausteine 10 bis 14 sind vorzugsweise als DDS ausgebildet. Insbesondere sind sie vorzugsweise identisch ausgebildet. Die Signalverarbeitungsbausteine 10 bis 14 erzeugen an ihren Ausgängen jeweils ein Taktsignal oder Hochfrequenzsignal, welches mit der Referenzfrequenz fx in Beziehung steht, insbesondere derart in Beziehung steht, dass es eine Frequenz aufweist, die der Bedingung n/m ^{∗} fx, m > n, n, m ∈ N entspricht.

Die Ausgangssignale der Signalverarbeitungsbausteine 10 bis 14 folgen Frequenzänderungen des Referenzsignals bzw. der Referenzfrequenz fx relativ und können in Amplitude und Phase durch ein Konfigurationswort beliebig eingestellt werden.

Der erste Signalverarbeitungsbaustein 10 dient dazu, aus der Frequenz fx ein Ausgangssignal mit einer per Software definierten Frequenz und Phase zu erzeugen. Hierbei wird ein Phasenkomparator 17 vorgesehen, dem zum einen das externe Taktsignal über den Eingang 4 und zum anderen der Ausgang des Signalverarbeitungsbausteins 10 zugeführt ist. Die Phasendifferenz wird durch Variation des Phasenwertes im Konfigurationswort ausgeregelt. Das so geregelte Ausgangssignal des ersten Signalverarbeitungsbausteins 10 kann als Bezugsphase in der Vorrichtung 1 verwendet werden und ermöglicht so eine Phasenregelung auch beim Fehlen eines externen Taktsignals oder bei Betrieb mit einer von dem externen Taktsignals abweichenden Frequenz des Hochfrequenzleistungssignals. Es stellt somit ein Referenzphasensignal dar.

Die zweiten Signalverarbeitungsbausteine 11, 12 erzeugen ein Hochfrequenzsignal, welches jeweils einem Leistungsverstärker 18, 19 zugeführt wird. Die Signalverarbeitungsbausteine 11, 12 und den Leistungsverstärker 18, 19 sind Bestandteil eines Leistungserzeugers 20, der an seinem Ausgang 21 ein Hochfrequenzleistungssignal ausgibt. Dieses kann sich zusammensetzen aus den Ausgangssignalen der Leistungsverstärker 18, 19, wobei auch die Ausgangssignale der Signalverarbeitungsbausteine als Hochfrequenzleistungssignale betrachtet werden können. Der Leistungserzeuger 20 kann in einem Pulsbetrieb betrieben werden, d.h. es können Pausenzeiten vorgesehen sein (Pulspausen), in denen kein Hochfrequenzleistungssignal ausgegeben wird. Hier ist es von besonderer Bedeutung, dass ein Referenzphasensignal erzeugt wird, das stets vorhanden ist, auch während einer Pulspause. Würde man für die Phasenregelung das Signal der Signalverarbeitungsbausteine 11 oder 12 verwenden, dann würde in Pulspausen aufgrund der Amplitudenmodulation die Phasenreferenz verschwinden. Eine Regelung müsste hier immer neu anfangen. Durch die Verwendung eines Referenzphasensignals bleibt diese auch ohne Hochfrequenzleistungssignal verfügbar.

Der dritte Signalverarbeitungsbaustein 14 erzeugt als Ausgangssignal eine Abtastfrequenz für eine synchrone digitale Messung, die einer Messeinrichtung 22 an einem Takteingang 23 zugeführt ist. Die Frequenz kann durch Variation des Konfigurationsworts des weiteren Signalverarbeitungsbausteins an die Messerfordernisse angepasst werden, wobei die Abtastung in einem Verhältnis n/m weiterhin synchron erfolgt. Das Abtastsignal wird an einen Analog-Digital-Wandler 24 gegeben, ebenso wie an eine Signalverarbeitungseinheit 25, z.B. ein FPGA. Der Analog-Digital-Wandler 24 steht mit einem Sensor 26 in Verbindung, der das Hochfrequenzleistungssignal, das am Ausgang 21 ausgegeben wird, erfasst. Die Signalverarbeitungseinheit 25 gibt am Ausgang 30 ein Messergebnis aus.

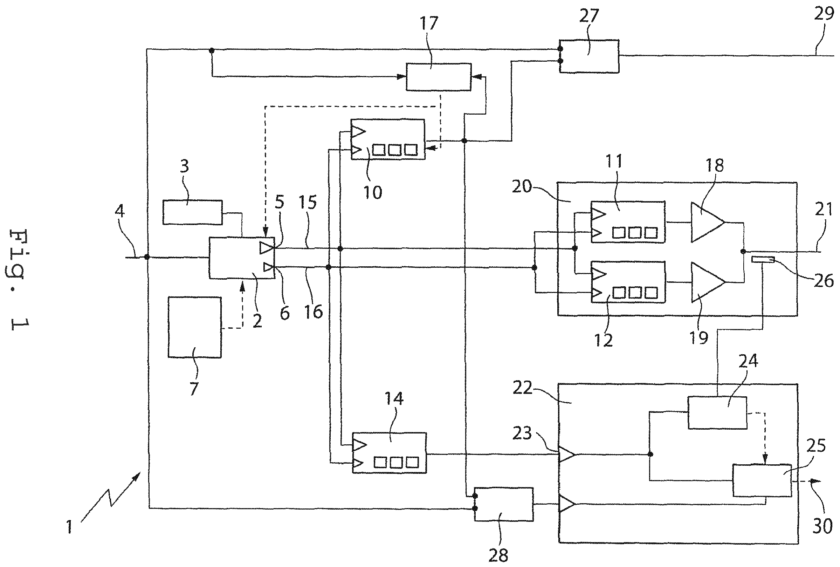

Die Figur 1 zeigt weiterhin zwei Umschalter 27, 28, wobei der Umschalter 27 dazu dient, entweder das externe Taktsignal direkt auf einen Taktausgang 29 zu geben oder das Referenzphasensignal am Ausgang des Signalverarbeitungsbausteins 10 extern verfügbar zu machen. Der andere Umschalter 28 ermöglicht es, sowohl das externe Taktsignal als auch das Signal mit der Referenzphase für eine Phasenmessung in der Messeinrichtung 22 zu nutzen. Die Umschalter27, 28 können programmierbar sein und per Software gesetzt werden. Die Wahl der Schalterstellung hängt von den Kundenanforderungen und Betriebsmodi ab .

## Patentansprüche

1. Vorrichtung (1) zur Erzeugung mehrerer Takt- oder Hochfrequenzsignale,
a) mit einem Referenzfrequenzerzeuger (2), der an einen Oszillator (3) angeschlossen ist und an seinem Ausgang (5) ein Referenzsignal mit einer Referenzfrequenz fx erzeugt, sowie
b) mit zumindest einem ersten, einem zweiten und einem weiteren Signalverarbeitungsbaustein (10-14), insbesondere DDS, die über eine erste Signalleitung (15) mit dem Referenzfrequenzerzeuger (2) verbunden sind und denen das Referenzsignal mit der Referenzfrequenz fx zugeführt wird und die konfiguriert sind, jeweils ein Ausgangssignal mit einer Frequenz < fx zu erzeugen, wobei
c) der erste Signalverarbeitungsbaustein (10) dazu ausgelegt ist, aus der Referenzfrequenz fx ein Ausgangssignal mit einer per Software definierten Frequenz und Phase zu erzeugen, sowie
d) mit einem Leistungserzeuger (20), der den zweiten Signalverarbeitungsbaustein (11) aufweist, wobei der Ausgang des zweiten Signalverarbeitungsbausteins (11) mit einem Leistungsverstärker (18) verbunden ist, der eingerichtet ist, aus dem Ausgangsignal des zweiten Signalverarbeitungsbausteins (11) ein Hochfrequenzleistungssignal zu erzeugen, sowie
e) mit einer digitalen Messeinrichtung (22), die mit einem Sensor (26) am Ausgang des Leistungserzeugers (20) verbunden ist, wobei der Ausgang des weiteren Signalverarbeitungsbausteins (14) mit einem Takteingang der Messeinrichtung (22) verbunden ist, um der Messeinrichtung (22) eine Abtastfrequenz zuzuführen, wobei
f) die Messeinrichtung (22) einen A/D-Wandler (24) aufweist, dem die Abtastfrequenz zugeführt ist und der mit dem Sensor (26) verbunden ist.

2. Vorrichtung nach Anspruch 1, **dadurch gekennzeichnet, dass** zumindest einer der Signalverarbeitungsbausteine (10-14) konfiguriert ist, ein Ausgangssignal mit einer Frequenz n/m ^{∗} fx mit n, m ∈ N und vorzugsweise m>n zu erzeugen.

3. Vorrichtung nach Anspruch 1 oder 2, **dadurch gekennzeichnet, dass** der Referenzfrequenzerzeuger (2) eingerichtet ist, ein Synchronisationssignal, insbesondere mit einer Frequenz fx/k, k ∈ N , zu erzeugen, wobei der Referenzfrequenzerzeuger (2) über eine zweite Signalleitung (16) mit zumindest einem der Signalverarbeitungsbausteine (10-14) verbunden ist.

4. Vorrichtung nach einem der vorhergehenden Ansprüche, **dadurch gekennzeichnet, dass** die Längen der Signalleitungen (15, 16) so aufeinander abgestimmt sind, dass die Signallaufzeiten auf den Signalleitungen (15, 16) gleich sind.

5. Vorrichtung nach einem der vorhergehenden Ansprüche, **dadurch gekennzeichnet, dass** zumindest einer der Signalverarbeitungsbausteine (10-14) durch ein Konfigurationswort konfigurierbar ist, wobei das Konfigurationswort die Frequenz, die Phase und/oder die Amplitude bezüglich des Referenzsignals des vom Signalverarbeitungsbaustein (10-14) erzeugten Ausgangssignals bestimmt.

6. Vorrichtung nach einem der vorhergehenden Ansprüche, **dadurch gekennzeichnet, dass** dem Referenzfrequenzerzeuger (2) ein externes Taktsignal (4) zugeführt ist, wobei der Referenzfrequenzerzeuger (2) eingerichtet ist, die Frequenz des externen Taktsignals zu ermitteln und auf die Referenzfrequenz umzusetzen.

7. Vorrichtung nach Anspruch 6, **dadurch gekennzeichnet, dass** der erste Signalverarbeitungsbaustein (10) mit seinem Signalausgang an einen Phasenkomparator (17) angeschlossen ist, dem auch das externe Taktsignal zugeführt ist, wobei der Ausgang des Phasenkomparators (17) mit dem ersten Signalverarbeitungsbaustein (10) verbunden ist.

8. Vorrichtung nach Anspruch 7, **dadurch gekennzeichnet, dass** der Ausgang des ersten Signalverarbeitungsbausteins (10) mit einem ersten Umschalter (27) verbunden ist, dem auch das externe Taktsignal zugeführt ist.

9. Vorrichtung nach einem der vorhergehenden Ansprüche 6 bis 8, **dadurch gekennzeichnet, dass** die Messeinrichtung (22) mit einem Umschalter (28) verbunden ist, dem das externe Taktsignal und das Ausgangssignal des ersten Signalverarbeitungsbausteins (10) zugeführt sind.

10. Vorrichtung nach Anspruch 9, **dadurch gekennzeichnet, dass** die Messeinrichtung (22) eine Signalverarbeitungseinheit (25) aufweist, der das Abtastsignal, das Ausgangssignal des Umschalters (28) und ein Signal des A/D-Wandlers (24) zugeführt sind und die eingerichtet ist, ein Messergebnis auszugeben.

11. Verfahren zur Erzeugung mehrerer Takt- oder Hochfrequenzsignale, bei dem
a) ein Referenzsignal erzeugt wird und
b) ein erstes, ein zweites und ein weiteres Ausgangssignal anhand des Referenzsignals erzeugt wird, wobei die Frequenz der Ausgangssignale kleiner ist als die Referenzfrequenz fx des Referenzsignals, wobei
c) das erste Ausgangssignal mit einer per Software definierten Frequenz und Phase erzeugt wird,
d) das zweite Ausgangssignal einem Leistungsverstärker (18) in einem Leistungserzeuger (20) zugeführt wird, der aus dem Ausgangssignal ein Hochfrequenzleistungssignal erzeugt,
e) das weitere Ausgangssignal einer Messeinrichtung (22) zugeführt wird, die mit einem Sensor (26) am Ausgang des Leistungserzeugers (20) verbunden ist, um der Messeinrichtung (22) eine Abtastfrequenz zuzuführen, wobei
f) die Abtastfrequenz einem A/D-Wandler (24) der Messeinrichtung (22), der mit dem Sensor (26) verbunden ist, zugeführt wird.

12. Verfahren nach Anspruch 11, **dadurch gekennzeichnet, dass** eines der Ausgangssignale mit einer Frequenz n/m ^{∗} fx mit n, m ∈ N und vorzugsweise m>n erzeugt wird.

13. Verfahren nach Anspruch 11 oder 12, **dadurch gekennzeichnet, dass** aus dem Referenzsignal ein Referenzphasensignal erzeugt wird, das bei einer Messung des Hochfrequenzleistungssignals verwendet wird.

14. Verfahren nach einem der vorhergehenden Ansprüche 11 bis 13, **dadurch gekennzeichnet, dass** aus dem Referenzsignal die Abtastfrequenz erzeugt wird, die bei der Messung des Hochfrequenzleistungssignals verwendet wird.

15. Verfahren nach einem der vorhergehenden Ansprüche 11 bis 14, **dadurch gekennzeichnet, dass** ein Synchronisationssignal, insbesondere mit einer Frequenz fx/k, k ∈ N erzeugt wird, das mehreren Signalverarbeitungsbausteinen (10-14) zugeführt wird, die Anhand der Referenzfrequenz das jeweilige Ausgangssignal erzeugen.

## Claims

1. A device (1) for generating a plurality of clock signals or high-frequency signals,
a) having a reference frequency generator (2), which is connected to an oscillator (3) and generates at its output (5) a reference signal with a reference frequency fx, and
b) having at least a first, a second and a further signal processing component (10-14), in particular DDS, which is connected to the reference frequency generator (2) via a first signal line (15) and to which the reference signal with the reference frequency fx is supplied, and which are configured, in each case to generate an output signal having a frequency < fx, wherein
c) the first signal processing component (10) is designed to generate an output signal having a frequency and phase defined by software from the reference frequency fx, and
d) having a power generator (20) which has the second signal processing component (11), wherein the output of the second signal processing component (11) is connected to a power amplifier (18) which is set up to generate a high-frequency power signal from the output signal of the second signal processing component (11), and
e) having a digital measuring apparatus (22) which is connected to a sensor (26) at the output of the power generator (20), wherein the output of the further signal processing component (14) is connected to a clock input of the measuring apparatus (22) in order to enable the measuring apparatus (22) to supply a sampling frequency, wherein
f) the measuring apparatus (22) has an A/D converter (24) to which the sampling frequency is supplied and which is connected to the sensor (26).

2. The device according to claim 1, **characterised in that** at least one of the signal processing components (10-14) is configured to generate an output signal with a frequency n/m * fx where n, m ∈ N and preferably m>n.

3. The device according to claim 1 or 2, **characterised in that** the reference frequency generator (2) is set up to transmit a synchronisation signal, in particular with a frequency fx/k, k ∈ N, wherein the reference frequency generator (2) is connected to at least one of the signal processing components (10-14) via a second signal line (16).

4. The device according to one of the preceding claims, **characterised in that** the lengths of the signal lines (15, 16) are matched to one another in such a way that the signal propagation times on the signal lines (15, 16) are the same.

5. The device according to one of the preceding claims, **characterised in that** at least one of the signal processing components (10-14) can be configured by a configuration word, wherein the configuration word specifies the frequency, the phase and/or the amplitude with respect to the reference signal of the output signal generated by the signal processing component (10-14).

6. The device according to one of the preceding claims, **characterised in that** the reference frequency generator (2) is supplied with an external clock signal (4), wherein the reference frequency generator (2) is set up to determine the frequency of the external clock signal and to convert it to the reference frequency.

7. The device according to claim 6, **characterised in that** the signal output of the first signal processing component (10) is connected to a phase comparator (17) to which the external clock signal is also supplied, wherein the output of the phase comparator (17) is connected to the first signal processing component (10).

8. The device according to claim 7, **characterised in that** the output of the first signal processing component (10) is connected to a first switch (27) to which the external clock signal is also supplied.

9. The device according to one of the preceding claims 6 to 8, **characterised in that** the measuring apparatus (22) is connected to a switch (28) to which the external clock signal and the output signal of the first signal processing component (10) are supplied.

10. The device according to claim 9, **characterised in that** the measuring apparatus (22) has a signal processing unit (25) to which the sampling signal, the output signal of the switch (28) and a signal of the A/D converter (24) are supplied and which is set up to output a measurement result.

11. A method for generating a plurality of clock signals or high-frequency signals, in which
a) a reference signal is generated, and
b) a first, a second and a further output signal is generated on the basis of the reference signal, wherein the frequency of the output signals is lower than the reference frequency fx of the reference signal, wherein
c) the first output signal is generated with a software-defined frequency and phase,
d) the second output signal is supplied to a power amplifier (18) in a power generator (20), which generates a high-frequency power signal from the output signal,
e) the further output signal is supplied to a measuring apparatus (22) which is connected to a sensor (26) at the output of the power generator (20) in order to supply a sampling frequency to the measuring apparatus (22), wherein
f) the sampling frequency is supplied to an A/D converter (24) of the measuring apparatus (22), which is connected to the sensor (26).

12. The method according to claim 11, **characterised in that** one of the output signals with a frequency n/m * fx where n, m ∈ N and preferably m>n is generated.

13. The method according to claim 11 or 12, **characterised in that** a reference phase signal used in a measurement of the high-frequency power signal is generated from the reference signal.

14. The method according to one of the preceding claims 11 to 13, **characterised in that** the sampling frequency used in the measurement of the high-frequency power signal is generated from the reference signal.

15. The method according to one of the preceding claims 11 to 14, **characterised in that** a synchronisation signal, in particular with a frequency fx/k, k ∈ N is generated, which is supplied to a plurality of signal processing components (10-14) which generate the respective output signal based on the reference frequency.

## Revendications

1. Dispositif (1) de génération d'une pluralité de signaux d'horloge ou de haute fréquence,
a) comprenant un générateur de fréquence de référence (2), lequel est connecté à un oscillateur (3) et lequel génère un signal de référence à une fréquence de référence fx à sa sortie (5), ainsi que
b) comprenant au moins un premier, un deuxième et un autre module de traitement du signal (10 à 14), en particulier DDS, lesquels sont connectés au générateur de fréquence de référence (2) par l'intermédiaire d'une première ligne de signal (15) et auxquels le signal de référence à la fréquence de référence fx est transmis et lesquels sont conçus pour générer respectivement un signal de sortie à une fréquence < fx, dans lequel
c) le premier module de traitement de signal (10) est conçu pour générer un signal de sortie à une fréquence et à une phase définies par logiciel à partir de la fréquence de référence fx, ainsi que
d) comprenant un générateur de puissance (20), lequel comporte le deuxième module de traitement du signal (11), dans lequel la sortie du deuxième module de traitement de signal (11) est connectée à un amplificateur de puissance (18), lequel est conçu pour générer un signal de puissance de haute fréquence à partir du signal de sortie du deuxième module de traitement du signal (11), ainsi que
e) comprenant un dispositif de mesure (22) numérique, lequel est connecté à un capteur (26) à la sortie du générateur de puissance (20), dans lequel la sortie de l'autre module de traitement du signal (14) est connectée à une entrée d'horloge du dispositif de mesure (22) pour fournir une fréquence d'échantillonnage au dispositif de mesure (22), dans lequel
f) le dispositif de mesure (22) comporte un convertisseur A/N (24) auquel la fréquence d'échantillonnage est transmise et lequel est connecté au capteur (26).

2. Dispositif selon la revendication 1, **caractérisé en ce que** l'au moins un des modules de traitement du signal (10 à 14) est conçu pour générer un signal de sortie à une fréquence n/m * fx avec n, m e N et, de préférence m > n.

3. Dispositif selon la revendication 1 ou 2, **caractérisé en ce que** le générateur de fréquence de référence (2) est conçu pour générer un signal de synchronisation, en particulier à une fréquence fx/k, k e N, dans lequel le générateur de fréquence de référence (2) est connecté à l'au moins un des modules de traitement du signal (10 à 14) par l'intermédiaire d'une seconde ligne de signal (16).

4. Dispositif selon l'une quelconque des revendications précédentes, **caractérisé en ce que** les longueurs des lignes de signal (15, 16) sont adaptées l'une à l'autre de telle sorte que les temps de propagation des signaux sur les lignes de signal (15, 16) sont identiques.

5. Dispositif selon l'une quelconque des revendications précédentes, **caractérisé en ce que** l'au moins un des modules de traitement du signal (10 à 14) est configurable par un mot de configuration, dans lequel le mot de configuration détermine la fréquence, la phase et/ou l'amplitude par rapport au signal de référence du signal de sortie généré par le module de traitement du signal (10 à 14).

6. Dispositif selon l'une quelconque des revendications précédentes, **caractérisé en ce qu'**un signal d'horloge (4) externe est fourni au générateur de fréquence de référence (2), dans lequel le générateur de fréquence de référence (2) est conçu pour déterminer la fréquence du signal d'horloge externe et pour la convertir en fréquence de référence.

7. Dispositif selon la revendication 6, **caractérisé en ce que** la sortie de signal du premier module de traitement du signal (10) est connectée à un comparateur de phase (17) auquel le signal d'horloge externe est également transmis, dans lequel la sortie du comparateur de phase (17) est connectée au premier module de traitement du signal (10).

8. Dispositif selon la revendication 7, **caractérisé en ce que** la sortie du premier module de traitement du signal (10) est connectée à un premier commutateur (27) auquel le signal d'horloge externe est également transmis.

9. Dispositif selon l'une quelconque des revendications précédentes 6 à 8, **caractérisé en ce que** le dispositif de mesure (22) est connecté à un commutateur (28) auquel le signal d'horloge externe et le signal de sortie du premier module de traitement de signal (10) sont fournis.

10. Dispositif selon la revendication 9, **caractérisé en ce que** le dispositif de mesure (22) comporte une unité de traitement du signal (25) à laquelle le signal d'échantillonnage, le signal de sortie du commutateur (28) et un signal du convertisseur A/N (24) sont fournis et laquelle est conçue pour générer un résultat de mesure.

11. Procédé de génération de plusieurs signaux d'horloge ou de haute fréquence, selon lequel
a) un signal de référence est généré et
b) un premier, un deuxième et un autre signal de sortie sont générés en fonction du signal de référence, dans lequel la fréquence des signaux de sortie est inférieure à la fréquence de référence fx du signal de référence, dans lequel
c) le premier signal de sortie est généré à une fréquence et à une phase définies par logiciel,
d) le deuxième signal de sortie est transmis à un amplificateur de puissance (18) dans un générateur de puissance (20), lequel génère un signal de puissance de haute fréquence à partir du signal de sortie,
e) l'autre signal de sortie est fourni à un dispositif de mesure (22), lequel est connecté à un capteur (26) à la sortie du générateur de puissance (20) pour fournir une fréquence d'échantillonnage au dispositif de mesure (22), dans lequel
f) la fréquence d'échantillonnage est fournie à un convertisseur A/N (24) du dispositif de mesure (22), lequel est connecté au capteur (26).

12. Procédé selon la revendication 11, **caractérisé en ce que** l'un des signaux de sortie est généré à une fréquence n/m * fx avec n, m e N et, de préférence m > n.

13. Procédé selon la revendication 11 ou 12, **caractérisé en ce qu'**un signal de phase de référence, lequel est utilisé dans une mesure du signal de puissance de haute fréquence, est généré à partir du signal de référence.

14. Procédé selon l'une quelconque des revendications précédentes 11 à 13, **caractérisé en ce que** la fréquence d'échantillonnage, laquelle est utilisée dans la mesure du signal de puissance de haute fréquence, est générée à partir du signal de référence.

15. Procédé selon l'une quelconque des revendications précédentes 11 à 14, **caractérisé en ce qu'**un signal de synchronisation généré, en particulier à une fréquence fx/k, k e N, est fournie à plusieurs modules de traitement du signal (10 à 14), lesquels génèrent le signal de sortie respectif en fonction de la fréquence de référence.
